# EUROPÄISCHE PATENTANMELDUNG

(11) **EP 2 437 295 A2**
(43) Veröffentlichungstag der Anmeldung: **04.04.2012**
(21) Anmeldenummer: 11176890.9
(22) Anmeldetag: 09.08.2011
(51) Int. Cl.: H01L 25/07

(54) **Leistungshalbleitermodul mit einem Grundmodul und einem Verbindungsmodul**

(30) Priorität: 01.10.2010 DE 102010041849
(71) Anmelder: Semikron Elektronik GmbH & Co. KG Patentabteilung, 90431 Nürnberg (DE)
(72) Erfinder: Stockmeier, Thomas, 90471 Nürnberg (DE); Göbl, Christian, 90441 Nürnberg (DE); Kroneder, Christian, 90596 Schwanstetten (DE)

(57) **Zusammenfassung**

Die Anmeldung betrifft ein Leistungshalbleitermodul mit einem elektrisch isolierenden Gehäuse, einem Grundmodul und einem Verbindungsmodul und ein zugeordnetes Verfahren zur dessen Herstellung, gekennzeichnet durch die folgenden Verfahrensschritte. Ausbilden von Halbleiterbaugruppen jeweils mit einem ersten Leitungselement mindestens einem hierauf angeordneten Leistungshalbleiterbauelement sowie einer ersten Kontakteinrichtung in elektrisch leitendem Kontakt zu dem ersten Leitungselement und einer zweiten Kontakteinrichtung in elektrisch leitendem Kontakt zu dem mindestens einen Leistungshalbleiterbauelement. Ausbilden des Grundmoduls durch elektrisch isoliertes Anordnen, mittels mindestens einer Isolationseinrichtung, der Halbleiterbaugruppen auf einer Grundplatte. Ausbilden des Verbindungsmoduls mit einem Isolierstoffformkörper und mindestens einer Verbindungseinrichtung. Anordnen des Verbindungsmoduls zum Grundmodul unter Ausbildung mindestens einer internen elektrisch leitenden Verbindung mittels einer Verbindungseinrichtung zwischen einer Kontakteinrichtung einer Halbleiterbaugruppe mit einer Kontakteinrichtung einer weiteren Halbleiterbaugruppe.

## Beschreibung

Die Erfindung beschreibt ein Leistungshalbleitermodul mit einem elektrisch isolierenden Gehäuse und hierin angeordnet und schaltungsgerecht verbunden einer Mehrzahl von Leistungshalbleiterbauelementen.

Derartige Leistungshalbleitermodule sind beispielhaft aus der DE 10 2006 034 964 B3 bekannt. Diese offenbart ein Leistungshalbleitermodul mit zwei serielle geschalteten Leistungshalbleiterbauelementen, vorzugsweise als Thyristoren ausgebildet, die elektrisch isoliert auf einer Grundplatte angeordnet sind. Mittels zweier Anschlusselemente sind diese Leistungshalbleiterbauelemente mit externen Kontaktelementen verbunden. Ein Verbindungselement bildet einerseits die interne elektrische Verbindung der Leistungshalbleiterbauelemente aus und dient weiterhin als weiteres externes Kontaktelement. Die modulinternen Verbindungen der Kontaktelemente mit den Leistungshalbleiterbauelementen ist hierbei als kraftschlüssige Verbindungen ausgebildet und weisen hierzu je Leistungshalbleiterbauelement eine eigene Druckeinrichtung auf.

Nachteilig an einem derartigen Leistungshalbleiterbauelement ist das aufwändige Herstellungsverfahren, bei dem eine Vielzahl von einzelnen Komponenten nacheinander zu dem Leistungshalbleitermodul verbunden werden muss.

Der Erfindung liegt die Aufgabe zugrunde ein modular aufgebautes Leistungshalbleitermodul und ein zugehöriges vereinfachtes Herstellungsverfahren vorzustellen, wobei vorgefertigte Module zueinander angeordnet werden können und zusätzlich die verschiede interne Schaltungsvarianten eines Leistungshalbleitermoduls einfach realisierbar sind.

Die Aufgabe wird erfindungsgemäß gelöst, durch ein Leistungshalbleitermodul gemäß Anspruchs 1, sowie durch ein Verfahren mit den Merkmalen des Anspruch 5. Bevorzugte Ausführungsformen sind in den jeweiligen abhängigen Ansprüchen beschrieben.

Den Ausgangspunkt der Erfindung bildet ein Leistungshalbleitermodul mit einem elektrisch isolierenden Gehäuse, einer Grundplatte und externen Kontaktelementen zur schaltungsgerechten externen Verbindung der Leistungshalbleiterbauelemente des Leistungshalbleitermoduls. Das erfindungsgemäße Leistungshalbleitermodul weist hierbei zwei wesentliche Teilmodule, nämlich ein Grundmodul und ein Verbindungsmodul auf, wobei das Grundmodul seinerseits als wesentliche Komponenten mindestens zwei Halbleiterbaugruppen aufweist. Das zugehörige erfindungsgemäße Herstellungsverfahren für ein Leistungshalbleitermodul wird im Folgenden gemeinsam mit dem Leistungshalbleitermodul selbst beschrieben.

Jede Halbleiterbaugruppe weist hierbei ein erstes Leitungselement, mindestens ein hierauf angeordnetes Leistungshalbleiterbauelement sowie eine erste Kontakteinrichtung zur Kontaktierung des ersten Leitungselements und eine oder jeweils eine zweite Kontakteinrichtung zur Kontaktierung des Leistungshalbleiterbauelements auf. Das Leitungselement dient somit zur elektrischen Verbindung einer ersten Kontaktfläche des Leistungshalbleiterbauelements und mittels der ersten Kontakteinrichtung deren weiterer elektrischer Verbindung innerhalb des Leistungshalbleitermoduls. Die zweite Kontakteinrichtung ist mittelbar oder unmittelbar mit einer zweiten Kontaktfläche, angeordnet auf einer der ersten Kontaktfläche gegenüberliegenden Hauptfläche des Leistungshalbleiterbauelements, verbunden. Für einen mittelbaren Kontakt kann auf der Kontaktfläche, zwischen dieser und dem zweiten Kontaktelement, noch ein zusätzliches, vorzugsweise scheibenförmiges, Leitungselement vorgesehen sein.

Bei rund ausgestalteten Leistungshalbleiterbauelementen ist es vorteilhaft die ersten Verbindungseinrichtungen als Hohlzylinder auszubilden, die in einem Abschnitt das Leistungshalbleiterbauelement umschließen. Ebenso ist es vorteilhaft die zweite Kontakteinrichtung als Zylinder oder als Hohlzylinder auszubilden. Speziell bei steuerbaren Leistungshalbleiterbauelementen ist die Ausbildung als Hohlzylinder besonders vorteilhaft, weil dann ein häufig mittig auf dem Leistungshalbleiterbauelement angeordneter Steueranschluss, beispielhaft mittels einer Kontaktfeder, kontaktiert werden kann. Selbstverständlich ist es notwendig die elektrisch notwendigen Isolationsabstände unterschiedlicher Potentiale einzuhalten, was im Rahmen des Herstellungsverfahrens beispielhaft durch Anordnung von gelartigen Isolationsstoffen erfolgen kann.

Im Rahmen des erfindungsgemäßen Herstellungsverfahrens eines Leistungshalbleitermoduls bildet die Ausbildung von derartigen Halbleiterbaugruppen einen wesentlichen Verfahrensschritt. Hierbei ist es bevorzugt, wenn thermisch oder elektrisch besonders beanspruchte Verbindungen als Drucksinterverbindungen ausgebildet sind. Insbesondere ist es bevorzugt, wenn alle elektrisch leitenden Verbindungen der Halbleiterbaugruppe als Drucksinterverbindungen ausgebildet werden.

Die Halbleiterbaugruppen sind, oder werden im Rahmen des Herstellungsverfahrens, auf der Grundplatte angeordnet, wobei zwischen dieser und dem Leitungselement der jeweiligen Halbleiterbaugruppe eine gemeinsame oder je Halbleiterbaugruppe eine Isolationseinrichtung vorgesehen ist. Diese Isolationseinrichtung dient der elektrischen Isolation gegen die Grundplatte, die somit bei der Verwendung des Leistungshalbleitermoduls dauerhaft auf einem Grundpotential liegen kann.

Eine bevorzugt vorhandene Verbindung zwischen der Grundplatte und der ggf. jeweiligen Isolationseinrichtung, kann ebenso wie eine ebensolche der Isolationseinrichtung zur Halbleiterbaugruppe als Klebeverbindung ausgebildet sein.

Es kann alternativ oder zusätzlich bevorzugt sein, wenn das Grundmodul weiterhin ein Grundgehäuse aufweist, das rahmenartig ausgebildet ist und Positioniermittel zur Anordnung der Halbleiterbaugruppen oder Teilen hiervon aufweist. Derartige Positioniermittel können beispielhaft ausgebildet sein als Führungselement sowie als Rastnasen zur Steck-Rast-Verbindung der Halbleiterbaugruppen mit dem Grundgehäuse im Rahmen des Herstellungsverfahrens.

Das Verbindungsmodul weist seinerseits einen Isolierstoffformkörper und mindestens eine interne Verbindungseinrichtung auf. Diese mindestens eine Verbindungseinrichtung dient der schaltungsgerechten Verbindung, genauer der Lastnicht der Steuerverbindung, zweier Halbleiterbaugruppen. Hierbei werden abhängig von der zu realisierenden Schaltungsvariante beispielhaft Verbindungen zwischen ersten oder zwischen zweiten Verbindungseinrichtungen zweier Halbleiterbaugruppen ausgebildet. Ebenso ist es möglich Verbindungen zwischen ersten und zweiten Verbindungseinrichtungen unterschiedlicher Halbleiterbaugruppen auszubilden.

Somit kann bei gleicher Ausgestaltung des Grundmoduls, nur durch ein geändertes Verbindungsmodul die interne Schaltungsvariante des Leistungshalbleitermoduls unterschiedlich ausgebildet werden.

Weiterhin kann die Verbindungseinrichtung ein eigenes, externes Kontakteelement aufweisen, das gemeinsam mit weiteren externen Kontaktelementen, die direkt mit ersten oder zweiten Verbindungseinrichtungen elektrisch verbunden sind, die externen Anschlusselemente des Leistungshalbleitermoduls ausbilden. Diese weiteren externen Kontaktelemente können in bevorzugter weise auch mittelbar mittels geeigneter Verbindungsmittel mit den zugeordneten Kontakteinrichtungen verbunden sein. Verbindungsmittel unterscheiden sich somit von Verbindungseinrichtungen dadurch, dass sie nur der Verbindung einer Kontakteinrichtung mit einem zugeordneten externen Kontaktelement dienen, während Verbindungseinrichtungen Halbleiterbaugruppen miteinander verbinden und bevorzugt zusätzlich mit einem externen Kontaktelement verbunden sind.

Für die Verbindung zwischen zwei zu verbindenden Kontakteinrichtungen und der zugeordneten Verbindungseinrichtung ist es bevorzugt diese kraft- oder formschlüssig auszubilden und herzustellen.

Für eine kraftschlüssige Verbindung ist es vorteilhaft im Verbindungsmodul mindestens ein Druckelement vorzusehen, das bei der Anordnung im Rahmen des Herstellungsverfahrens und anschießend dauerhaft eine Druckkraft auf das zugeordnete Verbindungselement und dessen Verbindung zu den zugeordneten ersten und zweiten Kontakteinrichtungen ausübt.

Das elektrisch isolierende Gehäuse des Leistungshalbleitermoduls ist bevorzugt ausschließlich ausgebildet aus dem Grundgehäuse des Grundmoduls und dem als Deckel wirkenden Isolierstoffformkörpers des Verbindungsmoduls. Hierbei ist es besonders bevorzugt, wenn die Verbindung des Grundgehäuses des Grundmoduls mit dem Isolierstoffformkörper des Verbindungsmoduls mittels einer Schraubverbindung oder mittels einer Schnapp-Rast-Verbindung erfolgt. Durch diese Verbindungvarianten ist bei einer kraftschlüssigen Verbindung der Kontakteinrichtungen mit einer zugeordneten Verbindungseinrichtung diese Verbindung besonders vorteilhaft herzustellen.

Die erfinderische Lösung wird an Hand der Ausführungsbeispiele gemäß den Fig. 1 bis 5 weiter erläutert.

Fig. 1 zeigt schematisch ein erfindungsgemäßes Leistungshalbleitermodul in seitlicher Schnittansicht.

Fig. 2 zeigt eine Draufsicht auf ein Grundmodul des Leistungshalbleitermoduls gemäß Fig. 1.

Fig. 3 bis 5 zeigen verschiedene Ausgestaltungen eines Verbindungsmoduls in unterschiedlichem Detailierungsgrad, sowie hierdurch realisierbare Schaltungsvarianten.

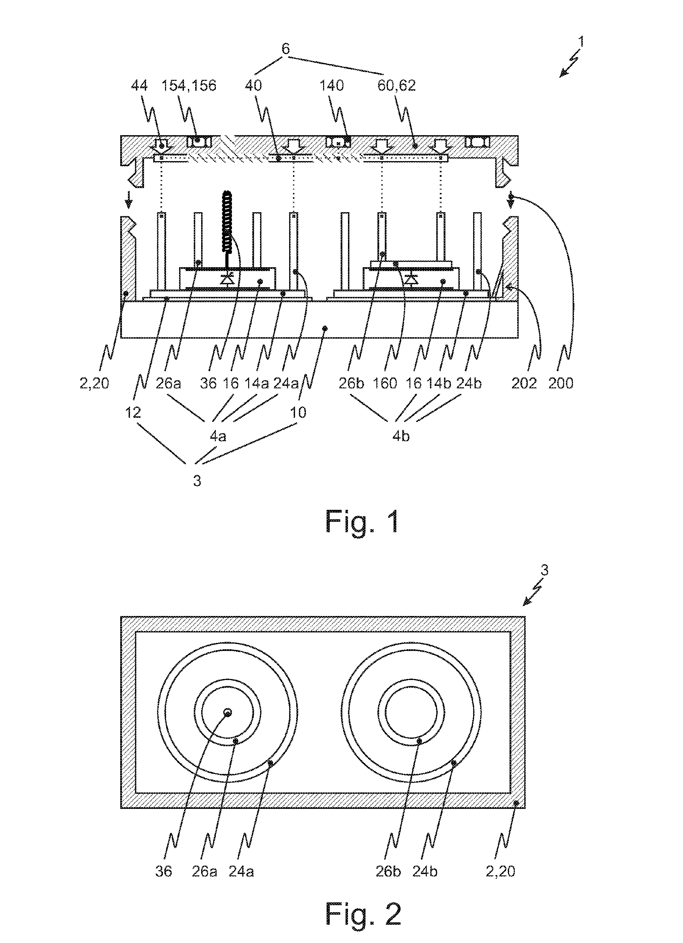

Fig. 1 zeigt schematisch ein erfindungsgemäßes Leistungshalbleitermodul (1) in seitlicher Schnittansicht. Dargestellt sind voneinander beabstandet ein Grund- (3) und ein Verbindungsmodul (6) diese Leistungshalbleitermoduls. Das Grundmodul (3) weist hier eine Grundplatte (10), üblicherweise aus einem sehr gut Wärme leitenden Metall, auf. Auf dieser Grundplatte (10) und dem Inneren des Leistungshalbleitermoduls (1) zugewandt sind hier zwei Isolationseinrichtungen (12) vorgesehen.

Auf diesen Isolationseinrichtungen (12) wiederum ist je eine Halbleiterbaugruppe (4 a/b) vorgesehen, die somit elektrisch isoliert von der Grundplatte (10) in dem Leistungshalbleitermodul (1) angeordnet ist. Die jeweilige Halbleiterbaugruppe (4 a/b) besteht aus einem Leitungselement (14), hier genau einem Leistungshalbleiterbauelement (16) und ersten und zweiten Kontakteinrichtungen (24 a/b, 26 a/b).

Das Leistungshalbleiterbauelement (16) bzw. dessen erste Kontaktfläche, genauer Lastkontaktfläche, ist vorzugsweise mittels einer Drucksinterverbindung mit dem ersten Leitungselement (14 a/b) verbunden, während dieses erste Leitungselement ebenfalls vorzugsweise mittels einer Drucksinterbindung mit der ersten Kontakteinrichtung (24 a/b) verbunden ist. Die zweite Kontaktfläche, ebenfalls eine Lastkontaktfläche, des Leistungshalbleiterbauelements (16) ist mit der zweiten Kontakteinrichtung (26 a/b), wiederum bevorzugt mittels einer Drucksinterverbindung, elektrisch leitend verbunden.

Speziell bei der Ausgestaltung des Leistungshalbleitermoduls (1) als Dioden- / Thyristormodul mit hoher Leistung ist es bevorzugt, wenn die Leistungshalbleiterbauelemente (16) eine runde, scheibenartige Grundform aufweisen. Bei dieser Ausgestaltung ist es dann auch bevorzugt, wenn die erste und zweite Kontakteinrichtung (24 a/b, 26 a/b) als metallische Hohlzylinder ausgebildet sind. Dies hat insbesondere den Vorteil, dass hierbei eine hohe Stromtragfähigkeit der Kontakteinrichtungen gegeben ist.

Zusätzlich weist die erste Halbleiterbaugruppe (4a) ein Hilfsanschlusselement (36) in Form einer Kontaktfeder zur Kontaktierung des Steueranschlusses des Leistungshalbleiterbauelements (16), hier eines Thyristors, auf. Weiterhin weist das Leistungshalbleiterbauelement (16) der zweiten Halbleiterbaugruppe (4b) auf seine der Grundplatte abgewandten Seite ein zweites Leitungselement (160) auf. Diese dient beispielhaft der mechanischen Entkopplung des Leistungshalbleiterbauelements (16), hier einer Diode, und der zugeordneten zweiten Kontakteinrichtung (26b).

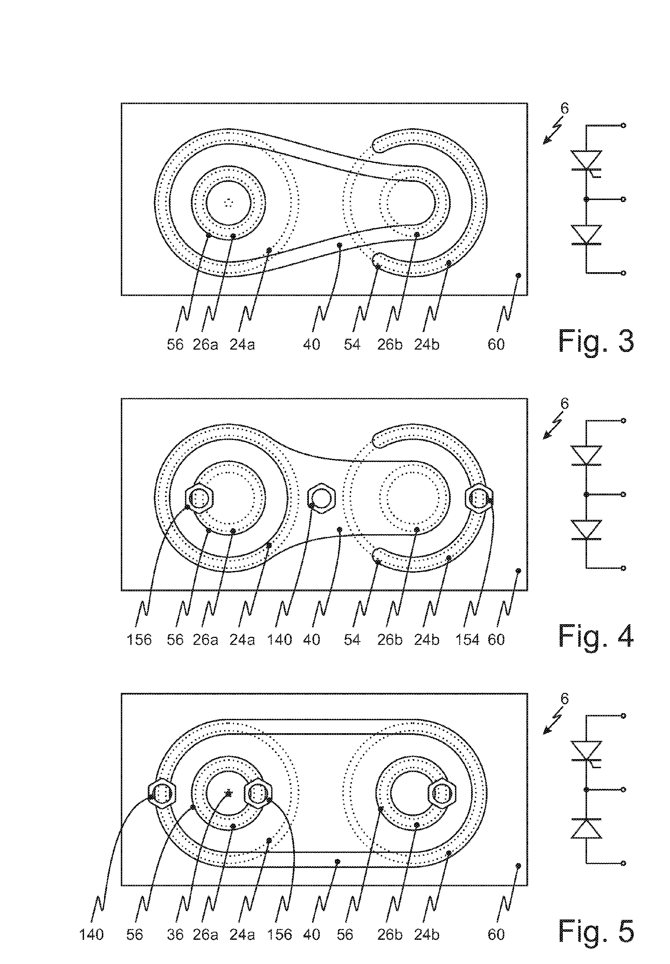

Von dem Grundmodul (3), aus Gründen der Übersichtlichkeit, beabstandet dargestellt ist das Verbindungsmodul (6), das seinerseits einen Isolierstoffformkörper (60) und in dieser Ausgestaltung genau eine Verbindungseinrichtung (40) aufweist. Die Verbindungseinrichtung (40) ist, vgl. auch Fig. 3 bis 5, als flächiger Metallformkörper ausgebildet, der Kontaktstellen zu den Kontakteirichtungen (24 a/b, 26 a/b) des Grundmoduls (3) aufweist und somit eine von meist mehreren Schaltungsvarianten des Leistungshalbleitermoduls (1) ausbildet. Die ausgebildete Schaltungsvariante bzw. die zugeordneten elektrischen Verbindungen innerhalb des Leistungshalbleitermoduls (1) sind durch gestrichelte Linien gekennzeichnet.

Es kann vorteilhaft sein, die Verbindungseinrichtung (40) spritzgusstechnisch mit dem Isolierstoffformkörper (60) zu verbinden, ebenso geeignet sind hier Schnapp- RastVerbindungen.

Weiterhin sind hier externe Kontaktelemente (140, 154, 156) als Teil des Verbindungsmoduls (6) vorgesehen, die der externen elektrischen Verbindung des Leistungshalbleitermoduls (1) dienen. Diese externen Kontaktelemente (140, 154, 156) sind hier beispielhaft als Teil von Schraubverbindungen ausgebildet. Elektrisch stehen diese externen Kontaktelemente (140, 154, 156) in mittelbarem oder unmittelbarem Kontakt mit den zugeordneten ersten und zweiten Kontakteinrichtungen (24 a/b, 26 a/b) oder mit der zugeordneten Verbindungseinrichtung (40).

Weiterhin weist das Verbindungsmodul (40) Druckelemente (44) auf, die bei der Anordnung des Verbindungsmoduls (6) zum Grundmodul (3) zumindest auf die Verbindungseinrichtung (40) und hierüber auf deren Kontaktflächen zu den zugeordneten ersten und zweiten Kontakteinrichtungen (24 a/b, 26 a/b) Druck ausübt und somit hierzwischen eine kraftschlüssigen elektrischen Verbindung ausbilden. Es können vorteihafterweise noch, nur in den Fig. 3 bis 5 dargestellte, Verbindungsmittel (54, 56) im Verbindungsmodul (6) vorgesehen sein, die ebenfalls mit Druck beaufschlagt werden und die mittelbare elektrische Verbindung zwischen weiteren externen Kontaktelemente (154, 156) und den zugeordneten ersten oder zweiten Kontaktelementen (24 a/b, 26 a/b) herstellen.

Alternativ kann es auch bevorzugt sein die elektrisch leitende Verbindung zwischen den Kontakteinrichtungen (24 a/b, 26 a/b) der Halbleiterbaugruppen (4 a/b) und der zugeordneten Verbindungseinrichtung (40) als eine formschlüssige Verbindungen auszubilden. Hierzu können bei Anordnung des Grundmoduls (3) zum Verbindungsmodul (6), zwischen dem Verbindungselement (40) und den Kontakteinrichtungen (24 a/b, 26 a/b) Steckverbindungen vorgesehen sein, die hierbei geschlossen werden.

In dieser Ausgestaltung des Leistungshalbleitermoduls (1) ist das elektrisch isolierende Gehäuse (2) ausgebildet durch ein Grundgehäuse (20) als weiterer Teil des Grundmoduls (3) und durch den Isolierstoffformkörper (60) des Verbindungsmoduls (6). Das Grundgehäuse (20) bildet somit einen rahmenartigen Teil des Gehäuses (2) aus, während der Isolierstoffformkörper (60) den Deckel (62) ausbildet. Besonders vorteilhaft ist es, wenn das Grundgehäuse (20) mit dem Deckel (62) mittel eine Schnapp- Rast-Verbindung (200) verbunden ist, die gleichzeitig die o.g. kraftschlüssige Verbindung ausbildet. Es kann allerdings neben weiteren möglichen Ausgestaltungen vorteilhaft sein eine Schraubverbindung zwischen Grundgehäuse (20) und Deckel (62) vorzusehen.

Weiterhin kann es vorteilhaft sein, wenn das Grundgehäuse (20) Positioniermittel (202) aufweist um die Halbleiterbaugruppen (4 a/b) positionsgerecht anzuordnen und / oder auf der Grundplatte (10) zu fixieren.

Das erfindungsgemäße Herstellungsverfahren weist zusammengefasst somit die Schritte auf:
- Ausbilden der Halbleiterbaugruppen (4 a/b);
- Ausbilden des Grundmoduls (3) mit den von der Grundplatte (10) elektrisch isolierten Halbleiterbaugruppen (4 a/b);
- Ausbilden des Verbindungsmoduls (6) mit der Verbindungseinrichtung;
- Anordnen des Verbindungsmoduls (6) mit dem Grundmodul (3) zum Leistungshalbleitermodul (1).

Fig. 2 zeigt eine Draufsicht auf ein Grundmodul (3) des Leistungshalbleitermoduls (1) gemäß Fig. 1. Dargestellt sind neben dem rahmenartigen Gehäuse (20) auch die ersten und zweiten Kontakteinrichtungen (24 a/b, 26 a/b) der jeweiligen Halbleiterbaugruppen (4 a/b). Diese Kontakteinrichtungen (24 a/b, 26 a/b) sind aus oben genannten Gründen hier als Hohlzylinder ausgebildet, die selbstverständlich ausreichend gegeneinander elektrisch isoliert angeordnet sind. Im Inneren des Hohlzylinders der zweiten Kontakteinrichtung (26a) der ersten Halbleiterbaugruppe (4a) ist wiederum die Kontaktfeder (36) des Steueranschlusses vorgesehen.

Die zweite Kontakteinrichtung der zweiten Halbleiterbaugruppe kann ebenso als Vollzylinder ausgebildet sein, da hier kein Hilfskontaktanschluss vorzusehen ist, wenn das zugeordnete Leistungshalbleiterbauelement wie oben beschrieben eine Diode ist.

Fig. 3 bis 5 zeigen verschiedene Ausgestaltungen eines Verbindungsmoduls in unterschiedlichem Detailierungsgrad, sowie hierdurch realisierbare Schaltungsvarianten.

Fig. 3 zeigt das Verbindungsmodul (6) gemäß Fig. 1, wobei hier wie auch in den weiteren Figuren die Kontakteinrichtungen (24 a/b, 26 a/b) des Grundmoduls (3) gestrichelt dargestellt sind. Die erste Kontakteinrichtung (24a) der ersten Halbleiterbaugruppe (4a) ist hier mittels der Verbindungseinrichtung (40) mit der zweiten Kontakteinrichtung (26b) der zweiten Halbleiterbaugruppe (4b) verbunden. Hierzu ist die Verbindungseinrichtung (40) als flächiger Metallformkörper ausgebildet, der in Draufsicht ein geschlossenes Band ausbildet.

Der zweiten Kontakteinrichtung (26a) der ersten Halbleiterbaugruppe (4a) ist ein ringförmiges Verbindungsmittel (56) zugeordnet, bevorzugt mit gleicher Dicke und gleicher horizontaler Lage in dem Verbindungsmodul (6) wie die Verbindungseinrichtung (40). Der ersten Kontakteinrichtung (24b) der zweiten Halbleiterbaugruppe (4b) ist ein Verbindungsmittel (54) zugeordnet, das als offener Ring ausgebildet ist und ebenfalls die gleiche Dicke und gleiche horizontale Lage in dem Verbindungsmodul (6) aufweist wie die Verbindungseinrichtung (40).

Es ist bevorzugt, wenn die Verbindungsmittel wie auch die Verbindungseinrichtung kraftschlüssig mittels oben genanntem Verfahren mit den Kontakteinrichtungen schaltungsgereicht verbunden sind. Hierdurch bildet sich dann für das Leistungshalbleitermodul die dargestellte Reihenschaltung eines Thyristors mit einer Diode aus, für die auch eine Mittelanzapfung vorgesehen aber ebenso wie die übrigen externen Kontaktelemente hier nicht dargestellt ist.

Fig. 4 zeigt eine weitere Schaltungsvariante, die Reihenschaltung zweier Dioden, die bei mechanisch gleicher Ausgestaltung des Grundmoduls (3), beispielhaft wie zu Fig. 1 und 2 beschrieben, realisiert werden kann. Wesentlich unterscheidet sich das Verbindungsmodul (6) dieser Ausgestaltung nur durch die Ausbildung der Verbindungseinrichtung (40) und des Kontaktmittels (56) zur zweiten Kontakteinrichtung (26a) der ersten Halbleiterbaugruppe (4a). Dieses Kontaktmittel (56) ist hier scheibenförmig ausgebildet, während die Verbindungseinrichtung (40) hier eine größere Querschnittsfläche im Vergleich zur Ausgestaltung gemäß Fig. 3 aufweist.

Zusätzlich dargestellt sind hier die externen Kontaktelemente (140, 154, 156), jeweils räumlich direkt den zugehörigen Verbindungmitteln (54, 56), bzw. der Verbindungseinrichtung (40) zugeordnet. Durch diese Verbindungsmittel (54, 56) werden die mittelbaren zwischen den externen Kontaktelemente (154, 156) und den zugeordneten Kontakteinrichtungen (24b, 26a) hergestellt.

Fig. 5 zeigt eine weitere bei mechanisch gleicher Ausgestaltung des Grundmoduls (3) realisierbare Schaltungsvariante, nämlich die serielle Schaltung eines Thyristors mit einer Diode, wobei deren Kathoden miteinander verbunden sind und dieser Verbindungspunkt die Mittelanzapfung darstellt.

Wesentlich unterscheidet sich diese Ausgestaltung des Verbindungsmoduls (6) durch die Form und Funktion der Verbindungseinrichtung (40). Diese verbindet hier die beiden ersten Kontakteinrichtungen (24 a/b) der beiden Halbleiterbaugruppen (4 a/b) miteinander. Ebenfalls dargestellt sind wiederum die externen Kontaktelemente (140, 154, 156). Ein Kontaktelement (140), das die Mittelanzapfung ausbildet ist dem Verbindungseinrichtung (40) zugeordnet, während die beiden weiteren Kontaktelemente (154, 156) jeweils den zweiten Kontakteinrichtungen (26 a/b) der Halbleiterbaugruppen (4 a/b) und damit den Anoden der Leistungshalbleiterbauelemente (16) zugeordnet sind.

## Patentansprüche

1. Leistungshalbleitermodul (1) mit einem elektrisch isolierenden Gehäuse (2), einem Grundmodul (3) und einem Verbindungsmodul (6), wobei das Grundmodul (3) eine Grundplatte (10) und hierauf durch mindestens eine Isolationseinrichtung (12) elektrisch isoliert angeordnete Halbleiterbaugruppen (4 a/b) jeweils mit einem ersten Leitungselement (14 a/b) mindestens einem hierauf angeordneten Leistungshalbleiterbauelement (16) sowie einer ersten Kontakteinrichtung (24) zur Kontaktierung und in elektrisch leitendem Kontakt zu dem ersten Leitungselements (14 a/b) und einer zweiten Kontakteinrichtung (26) zur Kontaktierung und in elektrisch leitendem Kontakt zu dem mindestens einen Leistungshalbleiterbauelement (16), aufweist und wobei
das Verbindungsmodul (6) einen Isolierstoffformkörper (60) mit mindestens einer internen Verbindungseinrichtung (40) aufweist, wobei diese mindestens eine Verbindungseinrichtung (40) jeweils den elektrischen Kontakt zwischen einer Kontakteinrichtung (24a, 26a) einer Halbleiterbaugruppe (4a) mit einer Kontakteinrichtung (24b, 26b) einer weiteren Halbleiterbaugruppe (4b) ausbildet.

2. Leistungshalbleitermodul nach Anspruch 1, wobei
das Verbindungsmodul (6) externe Kontaktelemente (140, 154, 156) aufweist, die schaltungsgerecht, mittelbar über Verbindungsmittel (54, 56) oder unmittelbar, mit einer ersten (24 a/b) oder mit einer zweiten Kontakteinrichtung (26 a/b) oder mit einer Verbindungseinrichtung (40) verbunden sind.

3. Leistungshalbleitermodul nach Anspruch 1, wobei
der Isolierstoffformkörper (60) den Deckel (62) des Leistungshalbleitermoduls (1) ausbildet.

4. Leistungshalbleitermodul nach Anspruch 1, wobei
das Grundmodul (3) selbst ein rahmenartiges elektrisch isolierendes Grundgehäuse (20) aufweist und dieses Grundgehäuse (20) Positioniermittel (202) für die Halbleiterbaugruppen (4 a/b) oder Teile hiervon aufweist.

5. Leistungshalbleitermodul nach Anspruch 3 und 4, wobei
das elektrisch isolierende Gehäuse (2) des Leistungshalbleitermoduls (1) ausschließlich aus dem Grundgehäuse (20) und dem Deckel (62) ausgebildet ist.

6. Verfahren zur Herstellung eines Leistungshalbleitermoduls (1) mit einem elektrisch isolierenden Gehäuse (2), einem Grundmodul (3) und einem Verbindungsmodul (6), **gekennzeichnet durch** die Verfahrensschritte
• Ausbilden von Halbleiterbaugruppen (4 a/b) jeweils mit einem ersten Leitungselement (14 a/b) mindestens einem hierauf angeordneten Leistungshalbleiterbauelement (16) sowie einer ersten Kontakteinrichtung (24 a/b) in elektrisch leitendem Kontakt zu dem ersten Leitungselement (14) und einer zweiten Kontakteinrichtung (26 a/b) in elektrisch leitendem Kontakt zu dem mindestens einen Leistungshalbleiterbauelement (16);
• Ausbilden des Grundmoduls (3) **durch** elektrisch isoliertes Anordnen, mittels mindestens einer Isolationseinrichtung (12), der Halbleiterbaugruppen (4 a/b) auf einer Grundplatte (10);
• Ausbilden des Verbindungsmoduls (6) mit einem Isolierstoffformkörper (60) und mindestens einer Verbindungseinrichtung (40);
• Anordnen des Verbindungsmoduls (6) zum Grundmodul (3) unter Ausbildung mindestens einer internen elektrisch leitenden Verbindung mittels einer Verbindungseinrichtung (40) zwischen einer Kontakteinrichtung (24a, 26a) einer Halbleiterbaugruppe (4a) mit einer Kontakteinrichtung (24b, 26b) einer weiteren Halbleiterbaugruppe (4b).

7. Verfahren gemäß Anspruch 6, wobei
die elektrisch leitende Verbindung zwischen Kontakteinrichtungen (24 a/b, 26 a/b) zweier Halbleiterbaugruppen (4 a/b) und der zugeordneten Verbindungseinrichtung (40) ausgebildet wird als eine kraftschlüssige Verbindung.

8. Verfahren gemäß Anspruch 7, wobei
zur Ausbildung der kraftschlüssigen Verbindung, bei Anordnung von Grundmodul (3) und Verbindungsmodul (6), im Verbindungsmodul (6) mindestens ein Druckelement (44) vorgesehen ist und dieses Druckelement (44) dauerhaft eine Druckkraft auf das zugeordnete Verbindungselement (40) und dessen Verbindung zu den zugeordneten ersten und zweiten Kontakteinrichtungen (24 a/b, 26 a/b).

9. Verfahren gemäß Anspruch 6, wobei
die elektrisch leitende Verbindung zwischen Kontakteinrichtungen (24 a/b, 26 a/b) zweier Halbleiterbaugruppen (4 a/b) und der zugeordneten Verbindungseinrichtung (40) ausgebildet wird als eine formschlüssige Verbindung.

10. Verfahren gemäß Anspruch 9, wobei
zur Ausbildung der formschlüssigen Verbindung, bei Anordnung von Grundmodul (3) und Verbindungsmodul (6), zwischen dem Verbindungselement (40) und den Kontakteinrichtungen (24 a/b, 26 a/b) Steckverbindungen vorgesehen sind.

11. Verfahren gemäß Anspruch 6, wobei
mindestens eine elektrisch leitenden Verbindung, bevorzugt aber alle elektrisch leitenden Verbindungen innerhalb der Halbleiterbaugruppen (4 a/b) als Drucksinterverbindungen ausgebildet werden.
